# EUROPÄISCHE PATENTANMELDUNG

(11) **EP 2 442 448 A1**
(43) Veröffentlichungstag der Anmeldung: **18.04.2012**
(21) Anmeldenummer: 11184692.9
(22) Anmeldetag: 11.10.2011
(51) Int. Cl.: H03K 17/96, H03K 17/78, H03K 17/00

(54) **Schaltung zum Ein- und/oder Ausschalten eines elektrischen Verbrauchers**

(30) Priorität: 13.10.2010 DE 102010042428
(71) Anmelder: E.G.O. Elektro-Gerätebau GmbH, 75038 Oberderdingen (DE)
(72) Erfinder: Ose, Dr.-Ing. Lutz, 75447 Sternenfels (DE)
(74) Vertreter: Patentanwälte Ruff, Wilhelm, Beier, Dauster & Partner

(57) **Zusammenfassung**

Eine Schaltung (10) zum Ein- und/oder Ausschalten eines elektrischen Verbrauchers (20) umfasst: ein elektrisch leitfähiges Bedienelement (11,), ein elektrisch betriebenes Leuchtmittel (12), das zwischen das Bedienelement und einen spannungsführenden Pol (L1) einer Wechselspannungsquelle derart eingeschleift ist, dass bei einer Betätigung des Bedienelements ein Strom durch das Leuchtmittel fließt, worauf das Leuchtmittel Licht emittiert, einen opto-elektrischen Wandler (13), der mit dem Leuchtmittel optisch gekoppelt ist, vor Umgebungslicht abgeschirmt ist und Licht, welches durch das Leuchtmittel emittiert wird, in elektrische Energie umwandelt, und ein Schaltmittel (14), das mit dem opto-elektrischen Wandler elektrisch gekoppelt ist und den elektrischen Verbraucher mit einer Versorgungsspannung (UV) verbindet oder von dieser trennt, wobei das Schaltmittel den elektrischen Verbraucher mit der Versorgungsspannung verbindet, wenn es durch den opto-elektrischen Wandler mit elektrischer Energie versorgt ist.

## Beschreibung

Die Erfindung betrifft eine Schaltung zum Ein- und/oder Ausschalten eines elektrischen Verbrauchers.

Bei elektrischen Verbrauchern, beispielsweise bei Fernsehgeräten, Haushaltsgeräten usw., die sich in einen Standby-Betriebszustand überführen lassen, ist es wünschenswert, die Leistungsaufnahme im Standby-Betriebszustand zu minimieren bzw. vollständig zu eliminieren.

Um die Leistungsaufnahme im Standby-Betriebszustand vollständig zu eliminieren, sind in der Regel mechanische Schaltkontakte notwendig, die den elektrischen Verbraucher im Standby-Betriebszustand bzw. im Aus-Betriebszustand vollständig von seiner Versorgungsspannung trennen. Ein Wiedereinschalten erfolgt in der Regel durch mechanisches Betätigen eines dem mechanischen Schaltkontakt zugeordneten Bedienelements, wodurch der mechanische Schaltkontakt geschlossen und der elektrische Verbrauch mit seiner Versorgungsspannung verbunden wird. Mit anderen Worten ist für das Einschalten ein mechanisch betätigbares Bedienelement notwendig.

### Aufgabe und Lösung

Der Erfindung liegt die Aufgabe zugrunde, eine Schaltung zum Ein-und/oder Ausschalten eines elektrischen Verbrauchers zur Verfügung zu stellen, mittels der die Leistungsaufnahme im Standby-Betriebszustand bzw. im Aus-Betriebszustand vollständig eliminiert werden kann und die zum Ein- und/oder Ausschalten des elektrischen Verbrauchers kein mechanisch betätigbares Bedienelement erfordert.

Die Erfindung löst diese Aufgabe durch eine Schaltung mit den Merkmalen des Anspruchs 1.

Bevorzugte Ausführungsformen sind Gegenstand der Unteransprüche, deren Wortlaut hiermit durch Bezugnahme zum Inhalt der Beschreibung gemacht wird.

Die Schaltung zum Ein- und/oder Ausschalten eines elektrischen Verbrauchers umfasst: ein elektrisch leitfähiges, insbesondere flächiges, Bedienelement, beispielsweise in Form einer elektrisch leitfähigen, flächigen Elektrode, wie sie beispielsweise als so genannte kapazitive Touch-Taste Verwendung findet, ein elektrisch betriebenes Leuchtmittel, das zwischen das Bedienelement und einen spannungsführenden Pol einer (Netz-)Wechselspannungsquelle derart (ohne oder mit weiteren zwischengeschalteten Elementen) eingeschleift ist, dass bei einer Betätigung des Bedienelements durch einen Benutzer ein Strom durch das Leuchtmittel fließt, wobei ein Stromkreis durch den Benutzer geschlossen wird, worauf das Leuchtmittel Licht emittiert, einen opto-elektrischen Wandler, der mit dem Leuchtmittel optisch gekoppelt ist, vor Umgebungslicht abgeschirmt ist und Licht, welches durch das Leuchtmittel emittiert wird, in elektrische Energie umwandelt, und ein Schaltmittel, das mit dem opto-elektrischen Wandler direkt oder indirekt elektrisch gekoppelt ist und den elektrischen Verbraucher mit einer Versorgungsspannung bzw. einer Energieversorgung verbindet oder von dieser trennt, wobei das Schaltmittel den elektrischen Verbraucher mit der Versorgungsspannung verbindet, wenn es durch den opto-elektrischen Wandler mit dessen elektrischer Energie versorgt ist. Während einer Einschaltphase, d.h. nachdem die Schaltung von einem nicht mit Energie versorgten Zustand in einen mit Energie versorgten Zustand überführt wird, ist das Schaltmittel bevorzugt ausschließlich durch den opto-elektrischen Wandler mit dessen elektrischer Energie versorgt. Wenn das Schaltmittel weder durch den opto-elektrischen Wandler noch durch weitere Energiequellen mit elektrischer Energie versorgt ist, kann das Schaltmittel derart ausgebildet sein, dass es für diesen Fall den elektrischen Verbraucher von der Versorgungsspannung trennt. Die Wechselspannungsquelle kann gleichzeitig die Versorgungsspannung des elektrischen Verbrauchers liefern bzw. bilden, d.h. die Versorgungsspannung und die durch die Wechselspannungsquelle gelieferte Wechselspannung können identisch sein.

In einer Weiterbildung ist das Bedienelement eine elektrisch leitfähige, insbesondere ebene, Berührfläche, beispielsweise eine metallisierte Fläche mit einem Flächeninhalt von ca. 1cm².

In einer Weiterbildung weist das Bedienelement einen ersten leitfähigen Berührabschnitt auf, der mit dem Leuchtmittel elektrisch gekoppelt ist, und einen zweiten, vom ersten leitfähigen Abschnitt beabstandeten und elektrisch isolierten zweiten leitfähigen Berührabschnitt auf, der mit einem Bezugspotential der Wechselspannungsquelle elektrisch gekoppelt ist, wobei der erste und der zweite Berührabschnitt bei einer Berührung des Bedienelements durch einen Benutzer mittels des Benutzers miteinander verbunden werden. Bevorzugt weist die Wechselspannungsquelle als Bezugspotential Erdpotential auf.

In einer Weiterbildung ist das elektrisch betriebene Leuchtmittel eine Glimmlampe bzw. eine Gasentladungsröhre.

In einer Weiterbildung ist zur Begrenzung eines durch den Benutzer fließenden Stroms ein hochohmiger Vorwiderstand vorgesehen, wobei das elektrisch betriebene Leuchtmittel und der Vorwiderstand in Serie zwischen das Bedienelement und den spannungsführenden Pol der Wechselspannungsquelle eingeschleift sind. Ein Widerstandswert des Vorwiderstands kann beispielsweise ca 1 MΩ betragen.

In einer Weiterbildung ist das Schaltmittel ein Relais, wobei die Relaisspule mittels des opto-elektrischen Wandlers mit Energie versorgt wird, wenn das Bedienelement betätigt ist, wobei die Arbeitskontakte des Relais für diesen Fall den elektrischen Verbraucher mit der Versorgungsspannung verbinden.

Alternativ kann das Schaltmittel ein Halbleiterschaltmittel sein, wobei ein Steuereingang des Halbleiterschaltmittels mittels des opto-elektrischen Wandlers mit Energie versorgt wird, wenn das Bedienelement betätigt ist, wobei für diesen Fall das Halbleiterschaltmittel den elektrischen Verbraucher mit der Versorgungsspannung verbindet.

In einer Weiterbildung ist eine Selbsthalteschaltung vorgesehen, die dazu ausgebildet ist, den elektrischen Verbraucher nach einer Betätigung des Bedienelements weiter mit der Versorgungsspannung zu beaufschlagen, nachdem dieser erstmalig mit der Versorgungsspannung beaufschlagt worden ist. Auf diese Weise kann sichergestellt werden, dass auch nach einer erfolgten Betätigung des Bedienelements der elektrische Verbraucher weiter mit der Versorgungsspannung verbunden bleibt. Bevorzugt ist die Selbsthalteschaltung dazu ausgebildet, das Schaltmittel derart anzusteuern, dass dieses seinen Schaltzustand beibehält, nachdem der elektrische Verbraucher erstmalig mit der Versorgungsspannung verbunden worden ist.

In einer Weiterbildung ist eine Verstärkerschaltung vorgesehen, die zwischen den opto-elektrischen Wandler und das Schaltmittel eingeschleift und dazu ausgebildet ist, aus der durch den opto-elektrischen Wandler zur Verfügung gestellten elektrischen Energie ein zur Ansteuerung des Schaltmittels geeignetes Ansteuersignal zu erzeugen.

### Kurzbeschreibung der Zeichnung

Vorteilhafte Ausführungsformen der Erfindung sind in den Zeichnungen schematisch dargestellt und werden nachfolgend beschrieben. Hierbei zeigt:
- Fig. 1: ein Blockdiagramm eines Teiles eines Haushaltsgeräts mit einem elektrischen Verbraucher und einer Schaltung zum Ein-und/oder Ausschalten des elektrischen Verbrauchers und
- Fig. 2: eine Ausführungsform eines Bedienelements.

### Detaillierte Beschreibung der Ausführungsbeispiele

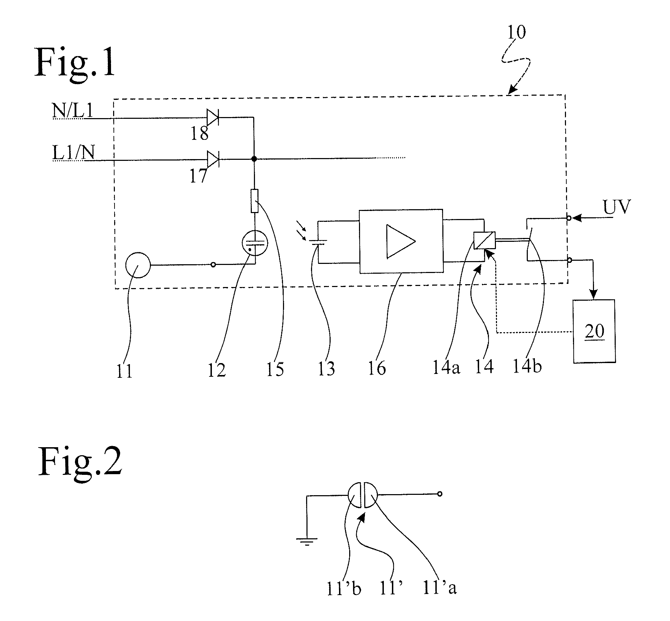

Fig. 1 zeigt schematisch ein Blockdiagramm eines Teils eines Haushaltsgeräts, beispielsweise eines Elektroherds, mit einem elektrischen Verbraucher 20, beispielsweise in Form einer Haushaltsgerätesteuerung, und einer Schaltung 10 zum Ein- und/oder Ausschalten des elektrischen Verbrauchers 20.

Die Schaltung 10 umfasst ein von einem nicht dargestellten Benutzer beispielsweise mittels eines Fingers betätigbares Bedienelement in Form einer elektrisch leitfähigen Berührfläche 11, ein elektrisch betriebenes Leuchtmittel in Form einer Glimmlampe 12, die mit einem hochohmigen Vorwiderstand 15 zwischen das Bedienelement 11 und einen spannungsführenden Pol L1 einer herkömmlichen Netzwechselspannungsquelle eingeschleift ist, einen opto-elektrischen Wandler in Form einer Solarzelle 13, die mit der Glimmlampe 12 optisch gekoppelt ist, vor Umgebungslicht abgeschirmt ist und Licht, welches durch die Glimmlampe 12 emittiert wird, in elektrische Energie umwandelt, und ein Schaltmittel in Form eines Relais 14, wobei eine Verstärkerschaltung 16 zwischen die Solarzelle 13 und das Relais 14 eingeschleift ist.

Aus Gründen der Verpolsicherheit sind optionale Dioden 17 und 18 vorgesehen, die zwischen den spannungsführenden Pol L1 der Netzwechselspannungsquelle bzw. einen Neutralleiter N der Netzwechselspannungsquelle und den Vorwiderstand 15 eingeschleift sind. Wenn auf die Dioden 17 und 18 verzichtet wird, ist dafür Sorge zu tragen, dass der Vorwiderstand 15 mit dem spannungsführenden Pol L1 der Netzwechselspannungsquelle und nicht mit dem Neutralleiter N verbunden wird.

Das Relais 14 ist mittels der Verstärkerschaltung 16 mit der Solarzelle 13 elektrisch gekoppelt und verbindet den elektrischen Verbraucher 20 mit einer Versorgungsspannung UV, wenn es durch die Solarzelle 13 bzw. die Verstärkerschaltung 16 mit elektrischer Energie versorgt ist.

Die Verstärkerschaltung 16 dient dazu, aus der durch die Solarzelle 13 zur Verfügung gestellten elektrischen Energie bzw. Spannung ein zur Ansteuerung des Relais 14 geeignetes Ansteuersignal bzw. eine geeignete Spannung zu erzeugen, d.h. eine Relaisspule 14a des Relais 14 derart zu bestromen, dass ein Schaltkontakt 14b des Relais 14 geschlossen wird, um den elektrischen Verbraucher 20 mit der Versorgungsspannung UV zu verbinden.

Bei einer Betätigung des Bedienelements 11 durch einen Benutzer wird über den Benutzer ein Stromkreis gegen Erdpotential geschlossen, sodass ein Strom durch die Glimmlampe 12 fließt, worauf diese Licht emittiert. In Folge wird die Relaisspule 14a geeignet bestromt, sodass der elektrischen Verbraucher 20 mit der Versorgungsspannung UV verbunden wird.

Nach einer Betätigung des Bedienelements 11 bewirkt eine nicht näher dargestellte Selbsthalteschaltung im elektrischen Verbraucher 20 eine Bestromung der Relaisspule 14a unabhängig von einer Betätigung des Bedienelements 11 derart, dass das Relais 14 seinen Schaltzustand beibehält, d.h. der elektrische Verbraucher 20 weiterhin mit der Versorgungsspannung UV beaufschlagt bleibt. Zum Ausschalten bzw. zum Überführen des Haushaltsgeräts in einen Standby- bzw. Aus-Betriebszustand beendet die Selbsthalteschaltung die Bestromung der Relaisspule 14a, wodurch der elektrische Verbraucher 20 von der Versorgungsspannung UV getrennt wird. Die Leistungsaufnahme im Standby-Betriebszustand bzw. im Aus-Betriebszustand kann folglich vollständig eliminiert werden.

Die Selbsthalteschaltung kann alternativ auch ein weiteres, nicht gezeigtes, vom elektrischen Verbraucher 20 angesteuertes Relais umfassen, dessen Schaltkontakt dem Schaltkontakt 14b des Relais 14 parallel geschaltet ist. Wenn der elektrische Verbraucher 20 dieses Relais derart ansteuert, dass dessen Schaltkontakt schließt, kann gewährleistet werden, dass der elektrische Verbraucher 20 selbst dann weiterhin mit der Versorgungsspannung UV verbunden bleibt, wenn der Schaltkontakt 14b nach einer Betätigung geöffnet wird.

Der Betätigungszustand des Bedienelements 11 kann zusätzlich im elektrischen Verbraucher 20 erfasst werden, um dem Bedienelement 11 weitere Funktionen zu geben. Hierzu sind weitere, herkömmliche, nicht gezeigte Elemente vorzusehen. Beispielsweise kann derart das Bedienelement 11 auch zum softwaregetriggerten Ausschalten des elektrischen Verbrauchers 20 verwendet werden.

Fig. 2 zeigt eine weitere Ausführungsform eines Bedienelements 11', das einen ersten leitfähigen, flächigen Berührabschnitt 11'a aufweist, der mit der Glimmlampe 12 elektrisch gekoppelt ist, und einen zweiten, vom ersten leitfähigen Abschnitt 11'a beabstandeten und elektrisch isolierten zweiten leitfähigen Berührabschnitt 11'b aufweist, der mit Erdpotential elektrisch gekoppelt ist, wobei der erste und der zweite Berührabschnitt bei einer Berührung des Bedienelements 11' durch einen Benutzer mittels des Benutzers miteinander verbunden werden. Ein derartiges Bedienelement ist beispielsweise bei einer schlechten Erdanbindung vorteilhaft, insbesondere bei elektrisch gut isolierenden Fußböden.

Die erfindungsgemäßen Ausführungsformen verbinden die Vorteile einer Bedienersteuerung mittels so genannten Touch-Tasten, die keine mechanische Betätigung erfordern, mit einem mechanischen Relaiskontakt, der eine echte Vermeidung von Standby-Energieverlusten gewährleistet.

Das Bedienelement in Form einer Touch-Control-Taste bzw. einer berührbaren Elektrode 11 bzw. 11' fungiert als Hauptschalter für eine nachgeschaltete Gerätesteuer-Baugruppe 20. Diese wird zum Aus- bzw. Einschalten (Herbeiführung des Standby- oder Bereitschafts-Zustandes der Steuerung 20) mit einem Bedienerfinger berührt. Der Elektrode nachgeschaltet ist eine Glimmlampe 12 mit Vorwiderstand 15. Das Ende dieser Reihenschaltung ist mit dem netzspannungsführenden Leiter L1 des geerdeten Stromnetzes verbunden. Insofern entspricht dieser Teil der Anordnung einem handelsüblichen Spannungsprüfer.

Das Licht der Glimmlampe 12 bei Berührung der Elektrode 11 mittels Finger trifft auf eine lichtdicht optisch gekoppelte Solarzelle 13 und erzeugt dort eine elektrische Gleichspannung. Diese wird, ggf. aufbereitet über einen Spannungsverstärker 16 o.ä. Schaltungsanordnungen, verwendet, um das Relais 14 einzuschalten. Die Glimmlampe 12 und die Solarzelle 13 bilden einen Optokoppler. Die Glimmlampe 12 und das Bedienelement 11 arbeiten bei Finger-Berührung nach dem Spannungsprüfer-Prinzip. Die Solarzellenenergie schaltet das Relais 14 ein. Die Steuerung 20 besitzt eine Selbsthaltefunktion für ihre Versorgungsspannung UV.

Es versteht sich, dass anstelle der Glimmlampe 12 auch vergleichbare Leuchtmittel verwendbar sind, beispielsweise LEDs usw.

Anstatt der Solarzelle 13 können selbstverständlich beliebige optoelektrische Wandler verwendet werden.

Anstelle des Relais 14 kann als Schaltmittel ebenfalls ein geeignetes Halbleiterschaltmittel eingesetzt werden, beispielsweise ein IGBT usw., wobei ein Steuereingang des Halbleiterschaltmittels mittels des opto-elektrischen Wandlers mit Energie versorgt wird, wenn das Bedienelement 11 betätigt ist, wodurch das Halbleiterschaltmittel den elektrischen Verbraucher 20 mit seiner Versorgungsspannung verbindet.

Die Schaltung kann auch als Zwischenadapter implementiert sein, der in eine herkömmliche Steckdose einsteckbar ist, wobei ein Netzstecker des elektrischen Verbrauchers in eine zugehörige Buchse des Zwischenadapters einsteckbar ist.

Um bei einem Haushaltsgerät mit herkömmlichem Netzstecker eine Verpolsicherheit zu gewährleisten, kann alternativ zu den Dioden 17 und 18 eine geeignete Anzeige im Haushaltsgerät vorgesehen sein, die anzeigt, ob der Netzstecker richtig in eine Steckdose eingesteckt ist. Für diesen Fall können die Dioden 17 und 18 entfallen.

## Patentansprüche

1. Schaltung (10) zum Ein- und/oder Ausschalten eines elektrischen Verbrauchers (20), umfassend:
- ein elektrisch leitfähiges Bedienelement (11, 11'),
- ein elektrisch betriebenes Leuchtmittel (12), das zwischen das Bedienelement und einen spannungsführenden Pol (L1) einer Wechselspannungsquelle derart eingeschleift ist, dass bei einer Betätigung des Bedienelements ein Strom durch das Leuchtmittel fließt, worauf das Leuchtmittel Licht emittiert,
- einen opto-elektrischen Wandler (13), der
- mit dem Leuchtmittel optisch gekoppelt ist,
- vor Umgebungslicht abgeschirmt ist und
- Licht, welches durch das Leuchtmittel emittiert wird, in elektrische Energie umwandelt, und
- ein Schaltmittel (14), das
- mit dem opto-elektrischen Wandler elektrisch gekoppelt ist und
- den elektrischen Verbraucher mit einer Versorgungsspannung (UV) verbindet oder von dieser trennt, wobei das Schaltmittel den elektrischen Verbraucher mit der Versorgungsspannung während einer Einschaltphase verbindet, wenn es ausschließlich durch den opto-elektrischen Wandler mit elektrischer Energie versorgt ist.

2. Schaltung nach Anspruch 1, **dadurch gekennzeichnet, dass** das Bedienelement eine elektrisch leitfähige Berührfläche ist.

3. Schaltung nach Anspruch 1 oder 2, **dadurch gekennzeichnet, dass** das Bedienelement einen ersten leitfähigen Berührabschnitt (11'a) aufweist, der mit dem Leuchtmittel elektrisch gekoppelt ist, und einen zweiten, vom ersten leitfähigen Berührabschnitt beabstandeten und elektrisch isolierten zweiten leitfähigen Berührabschnitt (11'b) aufweist, der mit einem Bezugspotential der Wechselspannungsquelle elektrisch gekoppelt ist, wobei der erste und der zweite Berührabschnitt bei einer Berührung des Bedienelements durch einen Benutzer mittels des Benutzers miteinander verbunden werden.

4. Schaltung nach einem der vorhergehenden Ansprüche, **dadurch gekennzeichnet, dass** die Wechselspannungsquelle als Bezugspotential Erdpotential aufweist.

5. Schaltung nach einem der vorhergehenden Ansprüche, **dadurch gekennzeichnet, dass** das elektrisch betriebene Leuchtmittel eine Glimmlampe ist.

6. Schaltung nach einem der vorhergehenden Ansprüche, **gekennzeichnet durch** einen Vorwiderstand (15), wobei das elektrisch betriebene Leuchtmittel und der Vorwiderstand in Serie zwischen das Bedienelement und den spannungsführenden Pol der Wechselspannungsquelle eingeschleift sind.

7. Schaltung nach einem der vorhergehenden Ansprüche, **dadurch gekennzeichnet, dass** Schaltmittel ein Relais ist, wobei die Relaisspule mittels des opto-elektrischen Wandlers mit Energie versorgt wird, wenn das Bedienelement betätigt ist.

8. Schaltung nach einem der vorhergehenden Ansprüche, **dadurch gekennzeichnet, dass** Schaltmittel ein Halbleiterschaltmittel ist, wobei ein Steuereingang des Halbleiterschaltmittels mittels des opto-elektrischen Wandlers mit Energie versorgt wird, wenn das Bedienelement betätigt ist.

9. Schaltung nach einem der vorhergehenden Ansprüche, **gekennzeichnet durch** eine Selbsthalteschaltung, die dazu ausgebildet ist, den elektrischen Verbraucher weiter mit der Versorgungsspannung zu verbinden, nachdem dieser während der Einschaltphase mit der Versorgungsspannung verbunden worden ist.

10. Schaltung nach Anspruch 9, **dadurch gekennzeichnet, dass** die Selbsthalteschaltung dazu ausgebildet ist, das Schaltmittel derart anzusteuern, dass dieses seinen Schaltzustand beibehält, nachdem der elektrische Verbraucher während der Einschaltphase mit der Versorgungsspannung verbunden worden ist.

11. Schaltung nach einem der vorhergehenden Ansprüche, **gekennzeichnet durch** eine Verstärkerschaltung (16), die zwischen den opto-elektrischen Wandler und das Schaltmittel eingeschleift und dazu ausgebildet ist, aus der **durch** den opto-elektrischen Wandler zur Verfügung gestellten elektrischen Energie ein zur Ansteuerung des Schaltmittels geeignetes Ansteuersignal zu erzeugen.
